# EUROPEAN PATENT APPLICATION

(11) **EP 1 970 992 A1**
(43) Date of publication of application: **17.09.2008**
(21) Application number: 08102050.5
(22) Date of filing: 27.02.2008
(51) Int. Cl.: H01P 7/08

(54) **Superconducting disk resonator**

(30) Priority: 15.03.2007 JP 2007066569
(71) Applicant: Fujitsu Ltd., Kawasaki-shi, Kanagawa 211-8588 (JP)
(72) Inventor: Akasegawa, Akihiko, Kawasaki-shi, Kanagawa 211-8588 (JP); Nakanishi, Teru, Kawasaki-shi, Kanagawa 211-8588 (JP); Sato, Keisuke, Kawasaki-shi, Kanagawa 211-8588 (JP)
(74) Representative: Stebbing, Timothy Charles

(57) **Abstract**

A superconducting disk resonator is disclosed that includes a dielectric base substrate having dielectric anisotropy, a disk type superconducting resonator pattern that is formed on the dielectric base substrate with superconducting material, and a pair of signal input/output lines arranged on the dielectric base substrate and extending in a straight line towards the disk type superconducting resonator pattern. The direction of dielectric anisotropy of the dielectric base substrate is oriented at ±90 degrees with respect to an extending direction of the pair of signal input/output lines.

## Description

### BACKGROUND OF THE INVENTION

### 1. Field of the Invention

The present invention relates to a superconducting disk resonator that is used in a transmitting front end such as a transmitting filter or antenna in the field of mobile communication and broadcasting.

### 2. Description of the Related Art

In view of the growing popularity and development of mobile phones, high-speed high-capacity transmission techniques are in great demand. A superconductor is favorably considered for application to a filter of a base station of a mobile communication system since it has relatively low surface resistance even in a high frequency domain compared to a conventional electrical conductor so that a low-loss high-Q value resonator may be realized.

In the case of using a superconducting filter as a receiving side band filter, transmission loss may be reduced and accurate frequency blocking characteristics may be realized, for example. In the case of using the superconducting filter as a transmitting side band filter, distortions created by a high power amplifier may be removed, for example. However, in this case, high power is needed to transmit high frequency signals and obstacles are created with respect to realizing power efficiency. Thus, techniques are in demand for realizing both miniaturization and efficient power consumption in a transmitting side band filter.

It is noted that a microstrip line pattern such as a hairpin line pattern or a straight line pattern is conventionally used as a resonator pattern. However, in such a microstrip line resonator, when high RF power is input particularly at the transmitting side, loss may be increased. This is due to the fact that high frequency waves such as microwaves are prone to concentrate at edge portions of a conductor which causes electric currents to concentrate at edge or corner portions of the microstrip line pattern so that the current concentration at these portions may exceed the critical current concentration of the superconductor.

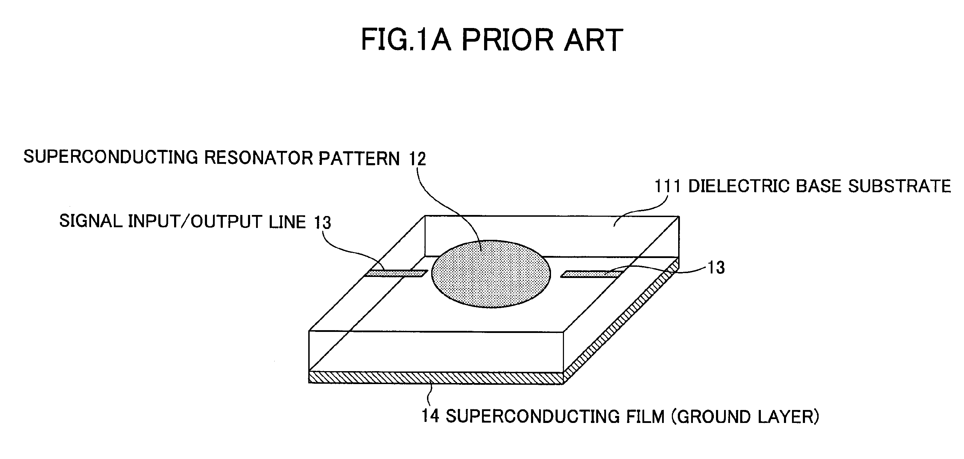

In view of such a problem, a superconducting resonator having a disk resonator pattern as is shown in FIG. 1A has been proposed in the prior art in order to reduce current concentration at the edge portions of the resonator pattern. Specifically, the illustrated superconducting disk resonator has a disk type superconducting resonator pattern (signal layer) 12 having fewer corner portions and edge portions formed on the surface of a dielectric base substrate 111 to realize high power response as a transmitting side filter. The illustrated superconducting disk resonator further includes signal input/output lines (feeders) 13 extending toward the vicinity of the superconducting resonator pattern 12 and a superconducting film 14 as a ground layer formed on the rear face of the dielectric base substrate 111.

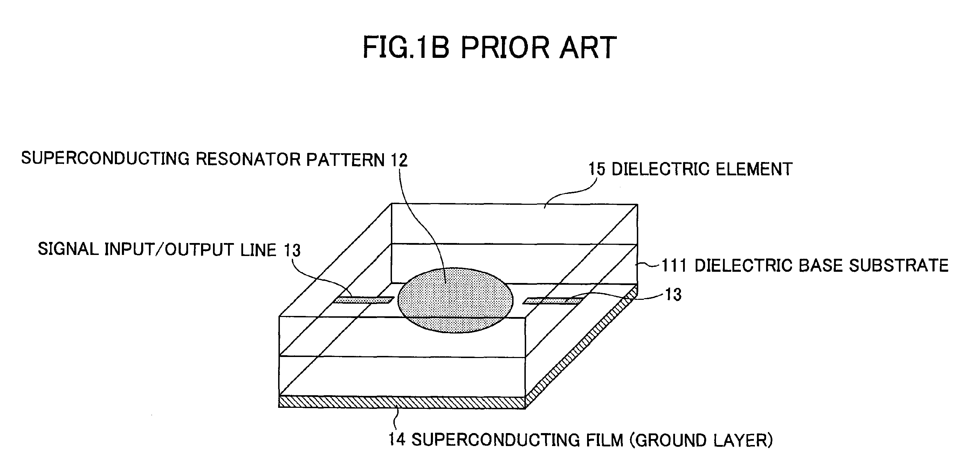

Also, a technique has been proposed in the prior art that involves laminating a dielectric element (or magnetic element) 15 on the disk type superconducting resonator pattern 12 as is shown in FIG. 1B in order to prevent current concentration at the peripheral portions (i.e., circumferential edge portions) of the disk type superconducting resonator pattern 12 (e.g., see Japanese Laid-Open Patent Publication No. 2006-352459).

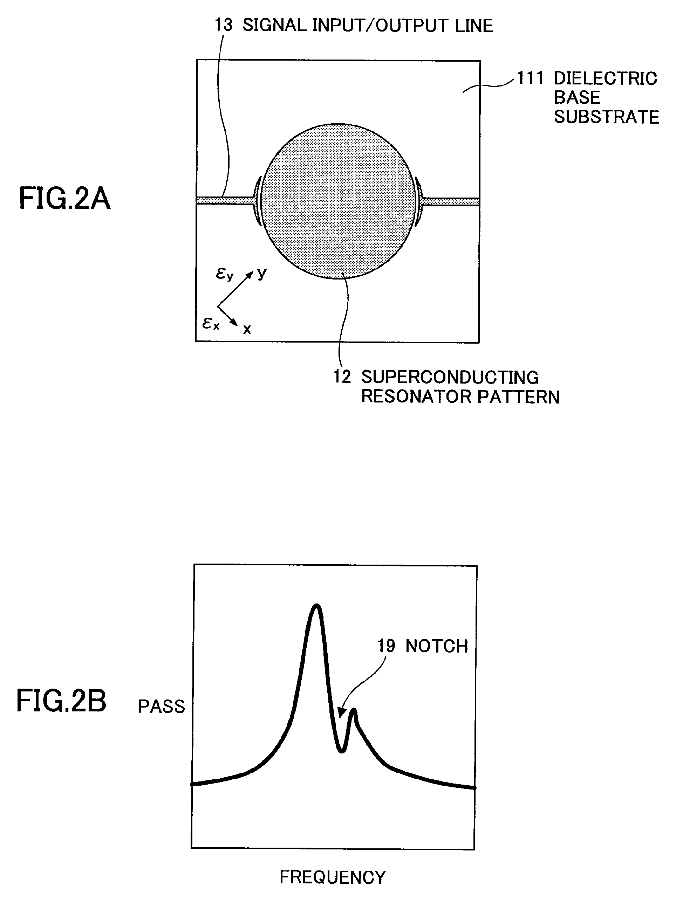

However, the inventors of the present invention have discovered that in a superconducting disk resonator, when a base substrate on which the superconducting resonator pattern is to be formed or a laminating element having dielectric or magnetic anisotropy (e.g., sapphire substrate) is used, a notch occurs on the resonance curve of the resonator. For example, when the base substrate 111 has anisotropy in directions ±45 degrees with respect to the extending direction of the signal input/output lines (feeders) 13 as is illustrated in FIG. 2A, a notch 19 occurs on the resonance curve as is shown in FIG. 2B.

More specifically, for example, in a case where a LaAlO₃ substrate is arranged on a regular single-crystal dielectric base substrate, a notch may not occur in a corresponding electromagnetic simulation and a normal resonance curve may be indicated. However, in actual measurement, a notch may occur at the high frequency side of the resonance curve. Such a notch occurring on the resonance curve may affect filtering properties and degrade device reliability, for example.

### SUMMARY OF THE INVENTION

An aspect of the present invention is directed to providing a superconducting disk resonator that is capable of preventing occurrence of a notch on a resonance curve and maintaining suitable frequency characteristics even when an anisotropic substrate is used.

Another aspect of the present invention is directed to providing a filter using such a superconducting disk resonator.

According to one embodiment of the present invention, a superconducting disk resonator is provided that includes:
a dielectric base substrate having dielectric anisotropy;
a disk type superconducting resonator pattern that is formed on the dielectric base substrate with superconducting material; and
a pair of signal input/output lines arranged on the dielectric base substrate and extending in a straight line towards the disk type superconducting resonator pattern; wherein
the direction of dielectric anisotropy of the dielectric base substrate is oriented at ±90 degrees with respect to the extending direction of the pair of signal input/output lines.

According to another embodiment of the present invention, a superconducting disk resonator is provided that includes:
a dielectric base substrate;
a disk type superconducting resonator pattern that is formed on the dielectric base substrate with superconducting material; and
a pair of signal input/output lines arranged on the dielectric base substrate and extending in a straight line towards the disk type superconducting resonator pattern; and
a laminating element having dielectric anisotropy or magnetic anisotropy that is arranged on the disk type superconducting resonator pattern; wherein
the direction of the dielectric anisotropy or the magnetic anisotropy of the laminating element is oriented at ±90 degrees with respect to the extending direction of the pair of signal input/output lines.

According to another embodiment of the present invention a superconducting filter is provided that includes a superconducting disk resonator according to an embodiment of the present invention.

### BRIEF DESCRIPTION OF THE DRAWINGS

FIGS. 1A and 1B are diagrams showing configurations of superconducting disk resonators according to the prior art;
FIGS. 2A and 2B are diagrams illustrating the occurrence of a notch on a resonance curve in the case of using an anisotropic dielectric base substrate;
FIGS. 3A-3C are diagrams showing a superconducting disk resonator according to an embodiment of the present invention and its resonance characteristics;
FIGS. 4A and 4B are graphs respectively showing electromagnetic simulation results and actual measurement results of a superconducting disk resonator that uses an anisotropic dielectric base substrate;
FIG. 5A is a diagram showing a resonator layout realizing anisotropy equivalent properties, and FIG. 5B is a graph showing electromagnetic simulation results of the layout shown in FIG. 5A;
FIG. 6A is a diagram showing another resonator layout realizing anisotropy equivalent properties, and FIG. 6B is a graph showing electromagnetic simulation results of the layout shown in FIG. 6A;
FIGS.7A and 7B are diagrams illustrating a method of evaluating dielectric anisotropy of a dielectric element according to an embodiment of the present invention;
FIGS. 8A and 8B are graphs illustrating the occurrence and disappearance of notches on resonance curves obtained using the evaluation method of FIGS. 7A and 7B; and
FIG. 9 is a diagram showing an exemplary modification of the superconducting disk resonator shown in FIG. 3.

### DESCRIPTION OF THE PREFERRED EMBODIMENTS

In the following, preferred embodiments of the present invention are described with reference to the accompanying drawings.

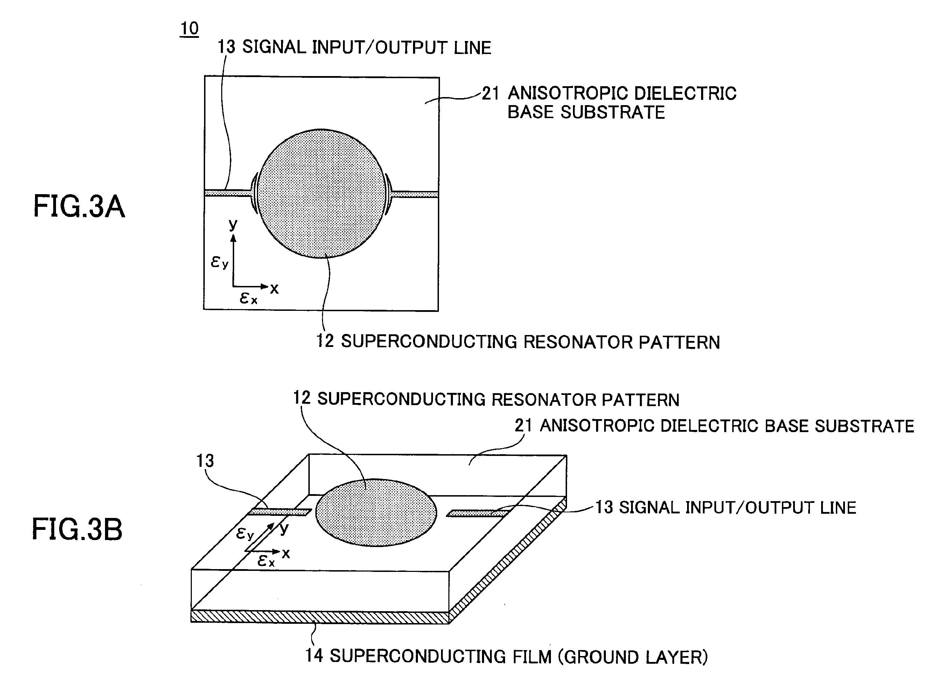

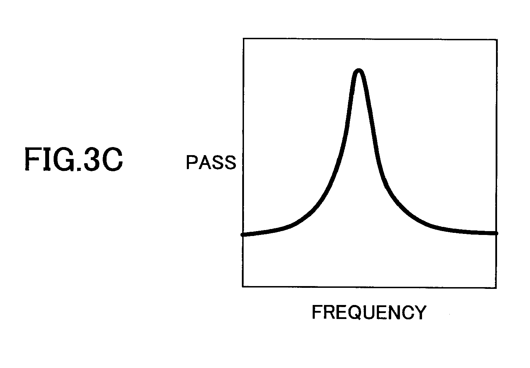

FIG. 3A is a plan view and FIG. 3B is a perspective view of a superconducting disk resonator 10 according to an embodiment of the present invention. FIG. 3C is a diagram showing frequency characteristics of the superconducting resonator 10 of FIGS. 3A and 3B.

The illustrated superconducting disk resonator 10 includes an anisotropic dielectric base substrate 21, a disk type resonator pattern (signal layer) 12 that is made of superconducting material and is formed on the dielectric base substrate 21, a pair of signal input/output lines 13 extending in a straight line towards the superconducting resonator pattern 12. The superconducting disk resonator 10 also has a superconducting film (ground layer) 14 arranged on the rear face of the dielectric base substrate 21. In one example, YBCO (Y-Ba-Cu-O) material may be used as the superconducting material of the resonator pattern 12, the signal input/output lines 13, and the ground layer 14.

In the above-described superconducting disk resonator 10, the dielectric base substrate 21 has dielectric anisotropy in directions ±90 degrees with respect to the extending direction of the signal input/output lines 13. To manufacture the superconducting disk resonator 10 having such a configuration, first, the direction of dielectric anisotropy of a dielectric substrate that is to become the base substrate is determined beforehand, and the determined anisotropic direction may be marked at an edge portion of the substrate, for example. Then, superconducting films are arranged on the surface and rear face of the dielectric substrate, and a patterning process is performed on the surface of the dielectric substrate to form a disk type resonator pattern 12 and a pair of signal input/output lines 13 in each of plural resonator areas provided on the dielectric substrate. In this patterning process, appropriate measures are taken such that the extending direction of the signal input/output lines 13 forms a 90-degree angle with respect to the direction of dielectric anisotropy of the dielectric substrate. Then, the dielectric substrate is cut into plural resonator areas to thereby fabricate superconducting disk resonators in each of these resonator areas.

By arranging the base substrate 21 to have dielectric anisotropy in directions ±90 degrees with respect to the extending direction of the signal input/output lines 13, frequency characteristics of the superconducting disk resonator 10 may be free of notches as is shown in FIG. 3C.

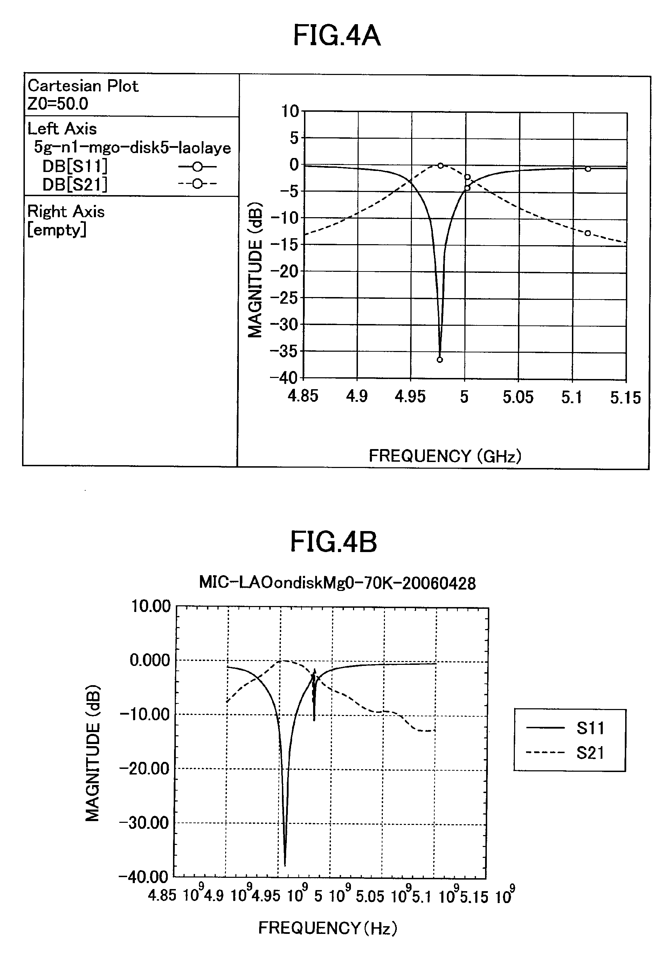

FIGS. 4A and 4B are graphs respectively showing electromagnetic simulation results and actual measurement results of a superconducting disk resonator that uses a LaAlO₃ substrate (anisotropic dielectric substrate) with dimensions of 20 mm × 20 mm × 0.5 mm, which LaAlO₃ substrate has a YBCO disk resonator pattern with a diameter of 11 mm and signal input/output lines formed on one side, and a ground layer formed on the other side. In the graph of FIG. 4A showing electromagnetic simulation results, normal resonance curves are plotted for both S11 and S21. However, as is shown in FIG. 4B, in actual measurement, notches occur at the high frequency side of both of the resonance curves of S11 and S21.

The inventors of the present invention have investigated the causes of such notch occurrence and have considered the fact that (1) a notch does not occur even in actual measurement results when an isotropic dielectric base substrate is used and a laminating element is not arranged on the superconducting disk resonator pattern but (2) even when an isotropic dielectric base substrate is used, a notch may occur in some cases when a laminating element having dielectric anisotropy or magnetic anisotropy is arranged on the superconducting resonator pattern, depending on the direction of anisotropy of the laminating element. Based on the above fact, the inventors of the present invention have come to believe that the direction of anisotropy has an influence on the occurrence of a notch. Accordingly, the following electromagnetic simulations were conducted with respect to superconducting disk resonator layouts arranged to realize dielectric anisotropy equivalent properties.

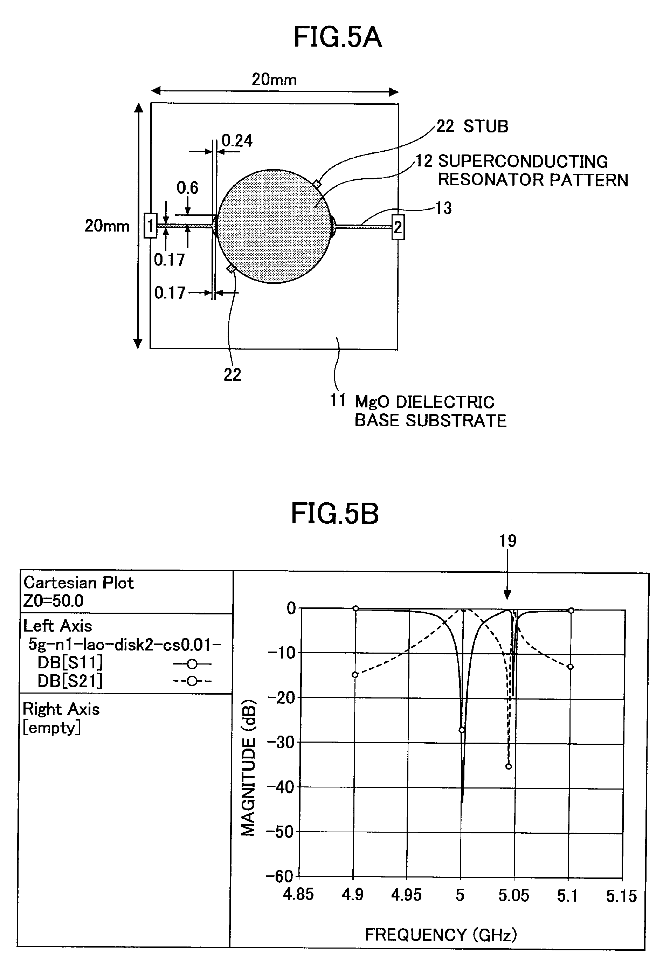

FIG. 5A is a diagram showing a layout of a superconducting disk resonator that uses a substantially isotropic MgO base substrate 11 with dimensions of 20 mm × 20 mm × 0.5 mm. The MgO base substrate 11 has a YBCO disk resonator pattern 12 with a diameter of 11 mm and a pair of signal input/output lines 13 formed thereon. The isotropic MgO base substrate 11 further has stubs 22 with dimensions of 0.2 mm × 0.2 mm arranged thereon in directions ±45 degrees with respect to the extending direction of the signal lines 13 to realize dielectric anisotropy equivalent properties in the corresponding directions. FIG. 5B is a graph showing electromagnetic simulation results obtained with respect to the superconducting disk resonator layout shown in FIG. 5A. As is shown in FIG. 5B, notches 19 occur at the high frequency side of the resonance curves of both S11 and S21.

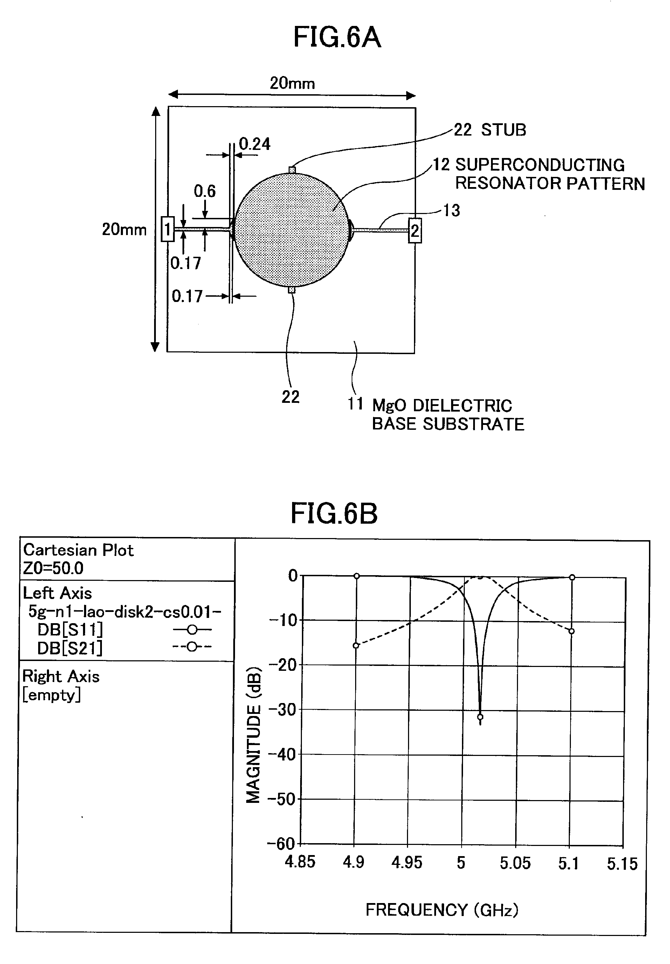

As a comparison example, FIG. 6A shows a layout equivalent to a resonator that uses a base substrate having dielectric anisotropy in directions ±90 degrees with respect to the extending direction of the signal input/output lines 13. Specifically, the illustrated layout of FIG. 6A has stubs 22 with dimensions of 0.2 mm ×

0.2 mm arranged in directions ±90 degrees with respect to the extending direction of the signal input/output lines 13. FIG. 6B is a graph showing electromagnetic simulation results of the layout shown in FIG. 6A. As is shown in this graph, notches do not occur on the resonance curves of S11 and S21 in this case.

Based on the above simulation results, it may be presumed that the occurrence of a notch on the resonance curve of a disk resonator is caused by the arrangement of dielectric or magnetic anisotropy in directions ±45 degrees with respect to the extending direction of the signal input/output lines 13 which causes coupling due to deviation from a degenerate mode and results in the occurrence of two resonance modes.

Thus, to maintain desirable characteristics by preventing the occurrence of notches in single-mode, a substrate having no dielectric anisotropy or magnetic anisotropy is preferably used, or a substrate having dielectric or magnetic anisotropy in directions ±90 degrees with respect to the extending direction of signal input/output lines is preferably used.

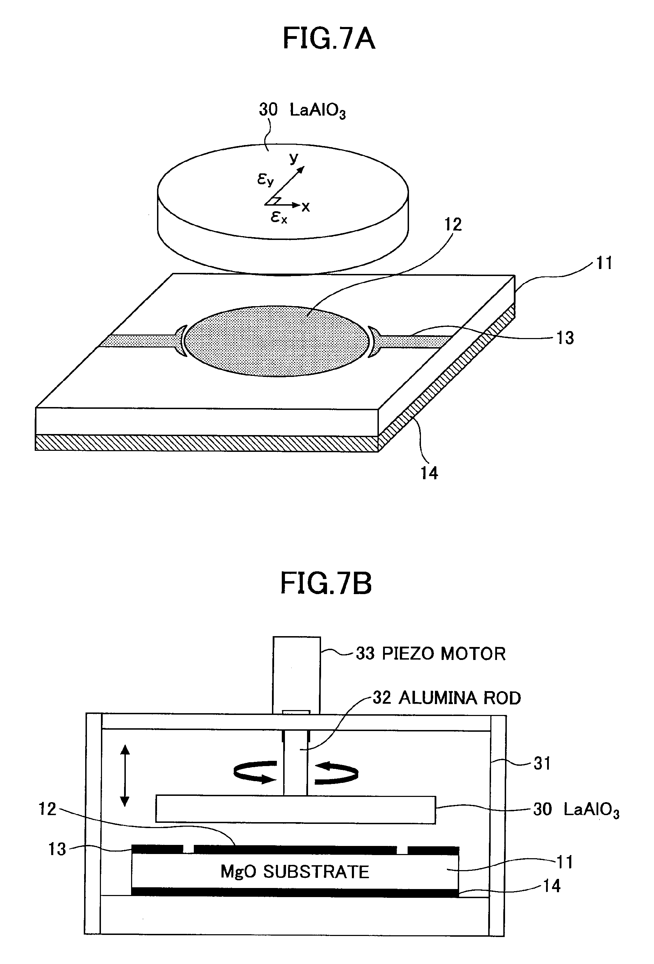

FIGS. 7A and 7B are diagrams describing a dielectric anisotropy evaluating method for confirming the above simulation results through actual measurement. Specifically, FIG. 7A is a diagram showing a superconducting disk resonator that is subject to dielectric anisotropy evaluation, and FIG. 7B is a diagram showing an apparatus used for dielectric anisotropy evaluation. As is shown in FIG. 7A, a superconducting disk resonator is fabricated by forming a disk type superconducting resonator pattern 12 with a diameter of 11 mm on the surface of a MgO base substrate 11 having a substantially isotropic dielectric constant, forming a pair of signal input/output lines 13 that extend in a straight line at opposite sides of the superconducting resonator pattern 12, and forming a ground layer 14 on the rear face of the MgO base substrate 11. A LaAlO₃ substrate 30 corresponding to an anisotropic dielectric substrate with a diameter of 14 mm and a thickness of 0.5 mm is held above the superconducting resonator pattern 12, the rotating angle of the LaAlO₃ substrate 30 with respect to the signal input/output lines 13 is changed, and frequency characteristics of the superconducting disk resonator at different rotating angles are measured. It is noted that the direction of dielectric anisotropy of the LaAlO₃ substrate 30 is determined beforehand by detecting the direction of crystal axis through X-ray diffraction, for example, and the anisotropic direction is marked on the LaAlO₃ substrate 30.

As is shown in FIG. 7B, the superconducting resonator of FIG. 7A is placed inside a chamber 31. A directing rod (alumina rod) 32 is rotatably attached to the upper face of the chamber 31 to hold the LaAlO₃ substrate 30 above the superconducting resonator pattern 12. The directing rod 32 is connected to a piezo motor 33 that is arranged outside the chamber 31 and is configured to move the LaAlO₃ substrate 30 spirally with respect to the superconducting resonator pattern 12.

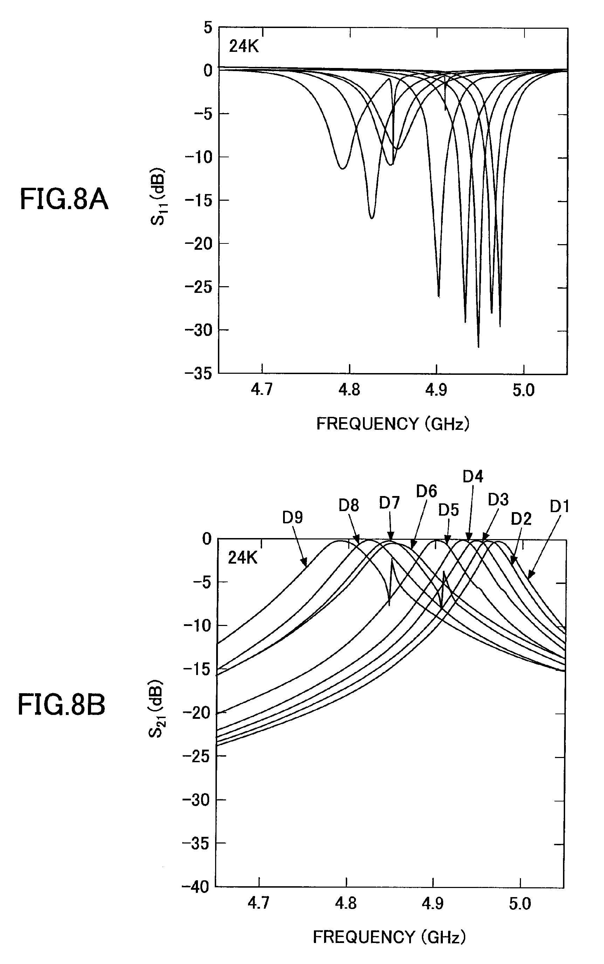

FIGS. 8A and 8B are graphs indicating actual measurements of S11 and S21, respectively, when the LaAlO₃ substrate 30 is at different positions (heights) D1-D9. The LaAlO₃ substrate 30 is rotated to move closer to the superconducting resonator pattern 12 as it advances from positions D1 through D9 (i.e., the angular position as well as the height position of the LaAlO₃ substrate 30 is changed). It is noted that by changing the position of the LaAlO₃ substrate 30 with respect to the height directions, the center frequency of the superconducting disk resonator may be shifted toward the low frequency side. When the LaAlO₃ substrate 30 is positioned relatively far away from the superconducting resonator pattern 12 (e.g., D1-D4), the influence of the direction of dielectric anisotropy on notch occurrence is relatively small. However, as the LaAlO₃ substrate 30 moves closer to the superconducting resonator pattern 12, the direction of dielectric anisotropy may have a notable influence on notch occurrence depending on the angular position of the LaAlO₃ substrate 30 with respect to the signal input/output lines 13. In the illustrated example of FIGS. 8A and 8B, notches occur when the LaAlO₃ substrate 30 is positioned at positions D5, D7, and D9, whereas the notches disappear when the LaAlO₃ substrate 30 is positioned at positions D6 and D8. It is noted that positions D6 and D8 correspond to parallel and perpendicular positions, respectively, with respect to the signal input/output lines 13.

As can be appreciated from the above descriptions, when a material having dielectric anisotropy or magnetic anisotropy is used as the dielectric base substrate on which a superconducting resonator pattern is to be formed or the dielectric/magnetic element to be laminated on the superconducting resonator pattern, the direction of anisotropy of the dielectric base substrate or the dielectric/magnetic element is preferably oriented at ±90 degrees with respect to the extending direction of signal input/output lines in order to prevent the occurrence of notches in the frequency characteristics of the superconducting disk resonator and maintain desirable resonance curves.

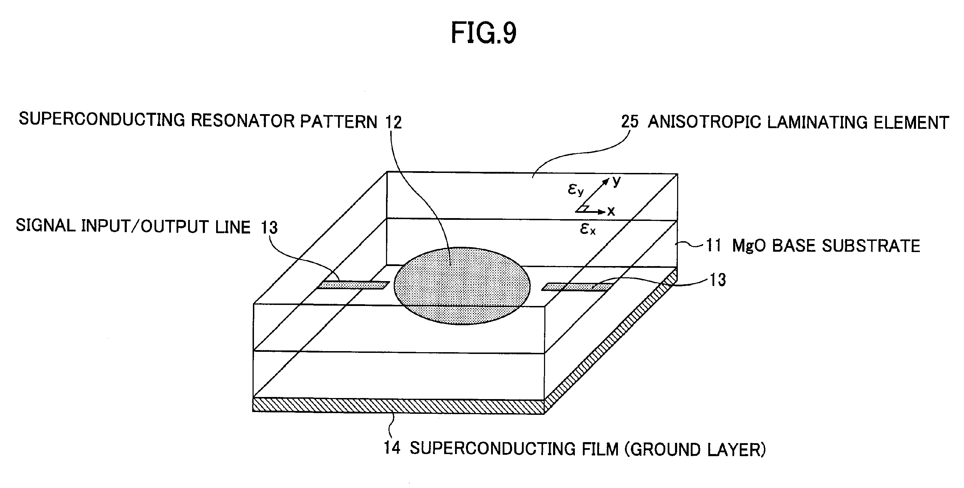

FIG. 9 is a diagram showing an exemplary modification of the superconducting disk resonator 10 shown in FIG. 3. In this example, a substantially isotropic MgO base substrate 11 is used as the dielectric substrate on which the superconducting resonator pattern 12 is to be formed, and a laminating element 25 for reducing current density intensification is arranged on the superconducting resonator pattern 12. The laminating element 25 may be a dielectric element having dielectric anisotropy or a magnetic element having magnetic anisotropy, for example. In this case, the direction of dielectric/magnetic anisotropy of the laminating element 25 is arranged to be ±90 degrees with respect to the signal input/output lines 13.

In the case of fabricating the above-described superconducting disk resonator, the direction of dielectric/magnetic anisotropy of a substrate that is to be the base material of the laminating element 25 is determined beforehand, and the substrate is cut into rectangles in a manner such that the direction of one side of the rectangle corresponds to the direction of dielectric/magnetic anisotropy of the substrate. In this way, a laminating element substrate is fabricated. Then, this laminating element substrate is arranged on the MgO base substrate 11 on which the superconducting resonator pattern 12, the signal input/output lines 13, and the ground layer 14 are formed in a manner such that the direction of dielectric/magnetic anisotropy of the laminating element substrate is oriented at ±90 degrees with respect to the signal input/output lines 13.

In one embodiment, the superconducting disk resonator shown in FIG. 3 or FIG. 9 may be arranged inside a metal package (not shown), the signal input/output lines 13 may be electrically connected to connectors provided at the metal package, and the entire metal package may be accommodated inside a low-temperature dewar so that the resulting structure may be used as a transmitting side filter for mobile communication.

In another embodiment, plural disk type superconducting resonator patterns 12 may be arranged between the signal input/output lines 13 formed on the base substrate. In yet another embodiment, a plural number of the superconducting disk resonators shown in FIG. 3 may be stacked to construct a multi-level filter.

It is noted that the material of the superconducting resonator pattern 12 is not limited to YBCO, and other types of oxide superconducting materials may be used as well. For example, superconducting materials such as RBCO (R-Ba-Cu-O) thin films that include Nd, Gd, Sm, or Ho as element 'R' instead of Y (yttrium), BSCCO (Bi-Sr-Ca-Cu-O), PBSCCO (Pb-Bi-Sr-Ca-Cu-O), and CBCCO (Cu-Bap-Caq-Cur-Ox, where 1.5 < p < 2.5, 2.5 < q <3.5, and 3.5 < r < 4.5) materials may be used.

Further, the present invention is not limited to these embodiments, and variations and modifications may be made without departing from the scope of the present invention.

The present application is based on and claims the benefit of the earlier filing date of Japanese Patent Application No. 2007-066569 filed on March 15, 2007, the entire contents of which are hereby incorporated by reference.

## Claims

1. A superconducting disk resonator comprising:
a dielectric base substrate (21) having dielectric anisotropy;
a disk type superconducting resonator pattern (12) that is formed on the dielectric base substrate with superconducting material; and
a pair of signal input/output lines (13) arranged on the dielectric base substrate and extending in a straight line towards the disk type superconducting resonator pattern; wherein
a direction of dielectric anisotropy of the dielectric base substrate is oriented at ±90 degrees with respect to an extending direction of the pair of signal input/output lines.

2. A superconducting disk resonator comprising:
a dielectric base substrate (11);
a disk type superconducting resonator pattern (12) that is formed on the dielectric base substrate with superconducting material; and
a pair of signal input/output lines (13) arranged on the dielectric base substrate and extending in a straight line towards the disk type superconducting resonator pattern; and
a laminating element (15) having dielectric anisotropy or magnetic anisotropy that is arranged on the disk type superconducting resonator pattern; wherein
a direction of the dielectric anisotropy or the magnetic anisotropy of the laminating element is oriented at ±90 degrees with respect to an extending direction of the pair of signal input/output lines.

3. The superconducting disk resonator as claimed in claim 1 or 2, wherein
at least two of the disk type superconducting resonator patterns are arranged in a line in between the signal input/output lines of the pair of signal input/output lines.

4. A superconducting filter comprising the superconducting disk resonator as claimed in claim 1 or 2.
